# EUROPEAN PATENT APPLICATION

(11) **EP 4 803 910 A1**
(43) Date of publication of application: **09.09.2026**
(21) Application number: 25161344.4
(22) Date of filing: 03.03.2025
(51) Int. Cl.: G01R 31/00, G01R 31/327, H01M 10/42

(54) **WELD DETECTION IN VOLTAGE TRACTION SYSTEMS**

(71) Applicant: Volvo Truck Corporation, 405 08 Göteborg (SE)
(72) Inventor: GIL RUBIO, Diego, GÖTEBORG (SE); KIZHAKKE MARATH, Avinas, MÖLNDAL (SE); MALM, Lars, GÖTEBORG (SE)
(74) Representative: Ström & Gulliksson AB

(57) **Abstract**

A computer system (100; 800) for performing a weld check in a traction voltage system (10), the computer system (10) comprising processing circuitry (102; 802) configured to: open a switch (22, 24) connected to the traction battery (20) and an electrical load (40) of the traction voltage system (10); measure a first voltage, *V₁*, between the traction battery (20) and ground reference (30), the first voltage, *V₁*, being measured at a battery side (10-1) of the traction voltage system (10) in relation to the switch (22, 24); measure a second voltage, *V₂*, between the electrical load (40) and ground reference (30), the second voltage, *V₂*, being measured at a load side (10-2) of the traction voltage system (10) in relation to the switch (22, 24); and compare the first and second voltages, *V₁*, *V₂*, to determine the presence of a weld in the switch (22, 24).

## Description

### TECHNICAL FIELD

The disclosure relates generally to traction voltage systems. In particular aspects, the disclosure relates to weld detection in voltage traction systems. The disclosure can be applied to mobile and stationary power applications. Mobile applications include heavy-duty vehicles, such as trucks, buses, and construction equipment, among other vehicle types. Mobile applications also include marine vessels, such as leisure boats, yachts, cargo ships, fishing boats, ferries, and patrol boats, among other vessel types. Stationary applications include power systems for e.g. hospitals, data centers, remote communication stations, industrial plants, emergency shelters, off-grid solar systems, factories, telecommunication stations, among other power systems. Although the disclosure may be described with respect to a particular power application, the disclosure is not restricted to any particular power application.

### BACKGROUND

In traction voltage systems involving traction batteries, ensuring the integrity of contactors is critical to system safety and reliability. A weld check is performed to verify that contactors are not welded shut, as welded contacts prevent the intended disconnection of a circuit, which can lead to safety and operational issues. In normal operation, a contactor opens to interrupt electrical contact between its terminals; however, if the contacts are welded together due to for example excessive current, arcing, or mechanical failure, the circuit remains closed even when the contactor is de-energized. This means electrical contact continues to exist between the two sides of the switch, potentially causing unintentional power flow, difficulty isolating faulty components, and increased risk of equipment damage or electrical hazards. Detecting welded contacts ensures the system can function safely and respond correctly during switching operations.

Traditionally, weld detection involves a sequence of opening and closing contactors while measuring voltages, a process that can be time-consuming and may reduce the lifespan of the pre-charge contactor due to frequent cycling.

### SUMMARY

Weld checks for contactors are traditionally conducted by sequentially opening and closing specific components while monitoring a voltage behavior in the circuit to ensure the contactors are not physically stuck. First, a positive contactor is opened, and the voltage over the electrical load is observed. If the voltage drops to nearly zero, it confirms the positive contactor has separated properly. Next, a pre-charge contactor is closed to allow downstream capacitors to charge gradually through a resistor, which limits inrush current. The voltage is then checked to confirm it rises back to the battery's voltage, ensuring proper circuit behavior. Finally, the negative contactor is opened, and a drop in voltage is verified to ensure the negative contactor is not welded.

The above-explained weld check procedure can be problematic because it relies on frequent use of the pre-charge contactor, which is not designed for high-duty cycles and may wear out quickly, reducing its lifetime. The process is also time-consuming since the pre-charge step involves waiting for capacitors to charge through a series resistor, adding delays. Additionally, this approach can increase system complexity and maintenance requirements, making it less efficient for applications requiring rapid diagnostics or high reliability.

The present disclosure therefore introduces a software-based approach to perform weld checks, eliminating reliance on the pre-charge capacitor and avoiding the need for hardware modifications. By not engaging the pre-charge contactor, this method reduces wear and extends component lifespan, enhancing system reliability. It also bypasses the time-consuming capacitor charging process, allowing for quicker diagnostics and streamlined maintenance. This approach supports rapid and reliable operations, offering a more robust solution compared to traditional methods. Additionally, its software-centric nature allows for cost-effective integration and easy updates, providing flexibility and reducing operational disruptions.

It shall be understood that the detection of a weld is not a binary determination of either a weld or no weld. The present approach is capable of identifying even partial welds, where only some areas of the contact surfaces are fused together. In such cases, the switch may still partially function, but the electrical continuity could be compromised, leading to unreliable performance.

In a first aspect of the disclosure there is accordingly provided a computer system for performing a weld check in a traction voltage system, the computer system comprising processing circuitry configured to open a switch connected to the traction battery and an electrical load of the traction voltage system; measure a first voltage, *V₁,* between the traction battery and ground reference, the first voltage, *V₁,* being measured at a battery side of the traction voltage system in relation to the switch; measure a second voltage, *V₂,* between the electrical load and ground reference, the second voltage, *V₂,* being measured at a load side of the traction voltage system in relation to the switch; and compare the first and second voltages, *V₁, V₂,* to determine the presence of a weld in the switch.

The first aspect of the disclosure may seek to determine the presence of a weld in a switch. A technical benefit may include providing a more efficient and accurate method for weld detection compared to prior art, reducing system downtime and maintenance requirements.

Optionally in some examples, including in at least one preferred example, the processing circuitry is configured to compare the first and second voltages, *V₁, V₂,* by calculating a statistical measure of the difference between the first and second voltages, *V₁, V₂,* over a predefined time period, wherein a positive gradient of the statistical measure indicates the absence of a weld in the switch, and a substantially zero of the statistical measure indicates the presence of a weld in the switch. A technical benefit may include enhancing detection accuracy by identifying changes in voltage behavior over time.

Optionally in some examples, including in at least one preferred example, the statistical measure is a Root Mean Square, RMS, value, *V_{RMS_diff}*, calculated using the formula: ${V}_{RMS _ diff} = \sqrt{\frac{1}{N} {\sum }_{i = 1}^{N} {\left({V}_{1}-{V}_{2}\right)}^{2}}$

A technical benefit may include providing precise quantification of voltage differences, improving diagnostic reliability.

Optionally in some examples, including in at least one preferred example, the predefined time period is a fixed value. A technical benefit may include ensuring consistent measurement intervals, allowing for standardized comparisons.

Optionally in some examples, including in at least one preferred example, the predefined time period is an adaptive value. A technical benefit may include allowing flexibility in response to dynamic system conditions, optimizing measurement accuracy.

Optionally in some examples, including in at least one preferred example, the processing circuitry is further configured to, prior to opening the switch, open an initial switch connected to the traction battery, the initial switch having a polarity opposite that of the switch; measure a third voltage, *V₃*, being a pole-to-pole voltage over the electrical load; and determine the presence of a weld in the initial switch in response to identifying a voltage drop in the third voltage, *V₃*, using a fourth voltage, *V₄*, being a pole-to-pole voltage over the traction battery, as reference. A technical benefit may include improved accuracy in detecting welds by utilizing voltage references.

Optionally in some examples, including in at least one preferred example, the processing circuitry is further configured to set a voltage threshold limit, and wherein the presence of a weld in the initial switch is determined in response to the voltage drop exceeding said voltage threshold limit. A technical benefit may include enhanced precision in weld detection through threshold-based analysis.

Optionally in some examples, including in at least one preferred example, the processing circuitry is configured to open a switch by causing transmission of a control signal to a switch actuator. A technical benefit may include efficient control over switch operations, reducing manual intervention.

Optionally in some examples, including in at least one preferred example, the processing circuitry is configured to obtain sampled input voltages from an analog-to-digital converter, and process the sampled input voltages to measure the voltages, *V₁, V₂, V₃, V₄.* A technical benefit may include increased accuracy and reliability in voltage measurements through digital processing.

Optionally in some examples, including in at least one preferred example, a measurement point of the first voltage, *V₁,* is connected in parallel with a resistor. A technical benefit may include reduced impact on the circuit during voltage measurement, maintaining system stability.

Optionally in some examples, including in at least one preferred example, a measurement point of the second voltage, *V₂*, is connected in parallel with a resistor. A technical benefit may include reduced impact on the circuit during voltage measurement, maintaining system stability.

In a second aspect of the disclosure there is provided a vehicle comprising an electrical load; a traction voltage system comprising a traction battery adapted to supply power to the electrical load; and a computer system of the first aspect configured to perform a weld check in the traction voltage system.

The second aspect of the disclosure may seek to determine the presence of a weld in a switch. A technical benefit may include providing a more efficient and accurate method for weld detection compared to prior art, reducing system downtime and maintenance requirements.

In a third aspect of the disclosure there is provided a computer-implemented method for performing a weld check in a traction voltage system, comprising opening, by processing circuitry of a computer system, a switch connected to the traction battery; measuring, by the processing circuitry, a first voltage, *V₁,* between the traction battery and ground reference, the first voltage, *V₁,* being measured at a battery side of the traction voltage system in relation to the switch; measuring, by the processing circuitry, a second voltage, *V₂,* between an electrical load and ground reference, the second voltage, *V₂,* being measured at a load side of the traction voltage system in relation to the switch; and comparing, by the processing circuitry, the first and second voltages, *V₁, V₂,* to determine the presence of a weld in the switch.

The third aspect of the disclosure may seek to determine the presence of a weld in a switch. A technical benefit may include providing a more efficient and accurate method for weld detection compared to prior art, reducing system downtime and maintenance requirements.

In a fourth aspect of the disclosure there is provided a computer program product comprising program code for performing, when executed by the processing circuitry, the computer-implemented method of the third aspect.

The fourth aspect of the disclosure may seek to enable new and/or legacy mobile and/or stationary power applications to be conveniently configured, by software installation/update, to determine the presence of a weld in a switch. A technical benefit may include providing a more efficient and accurate method for weld detection compared to prior art, reducing system downtime and maintenance requirements.

In a fifth aspect of the disclosure there is provided a non-transitory computer-readable storage medium comprising instructions, which when executed by processing circuitry, cause the processing circuitry to perform the computer-implemented method of the third aspect.

The fifth aspect of the disclosure may seek to enable new and/or legacy mobile and/or stationary power applications to be conveniently configured, by software installation/update, to determine the presence of a weld in a switch. A f benefit may include providing a more efficient and accurate method for weld detection compared to prior art, reducing system downtime and maintenance requirements.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
**FIG. 1** is an example vehicle comprising an exemplary traction voltage system.
**FIG. 2** is an example traction voltage system where an exemplary weld check can be conducted.
**FIG. 3** shows three diagrams of data in an implementation of a weld check method using a first exemplary traction voltage system.
**FIG. 4** shows three diagrams of data in an implementation of a weld check method using a second exemplary traction voltage system.
**FIG. 5** shows three diagrams of data in an implementation of a weld check method using a third exemplary traction voltage system.
**FIG. 6** shows three diagrams of data in an implementation of a weld check method using a fourth exemplary traction voltage system.
**FIG. 7** is an exemplary flow chart of a method for performing a weld check according to an example.
**FIG. 8** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

The present disclosure introduces a software-based approach to performing weld checks, eliminating the reliance on pre-charge capacitors and hardware modifications. This approach involves opening a switch in the traction voltage system and performing two key voltage measurements: one between the traction battery and ground, and another between the electrical load and ground. By comparing these measurements, the system can determine the presence of a weld in the switch. This approach reduces wear on components by avoiding the frequent use of the pre-charge contactor, thereby extending the lifespan and enhancing the reliability of the system. It also bypasses the time-consuming process of capacitor charging, enabling quicker diagnostics and more efficient maintenance. The software-centric solution supports rapid and reliable operations, offering a more robust alternative to traditional methods. Additionally, it allows for cost-effective integration and easy updates, providing flexibility and reducing operational disruptions.

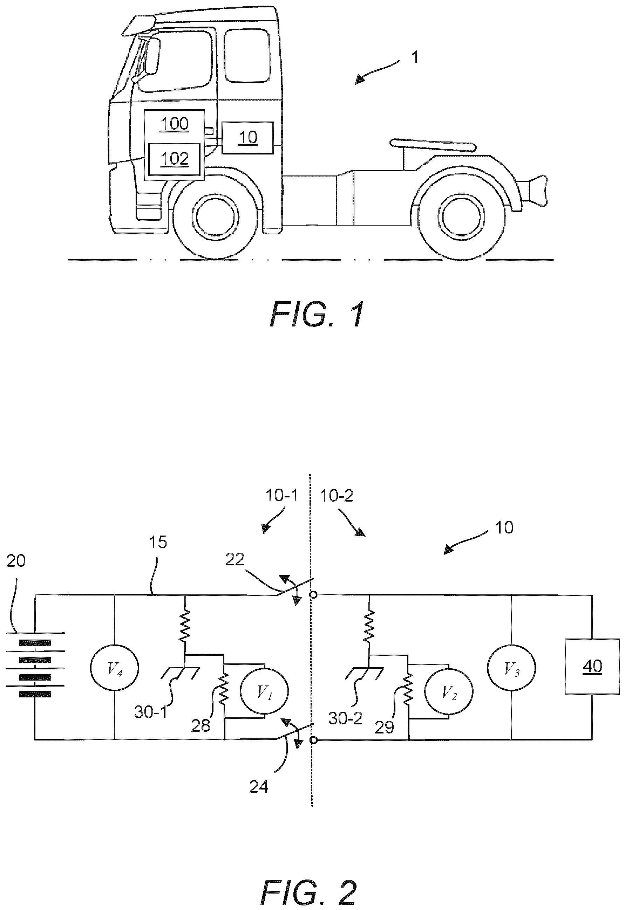

**FIG. 1** depicts a power application in the form of an electric vehicle **1.** The present disclosure will hereinafter refer to the electric vehicle **1,** although it shall be understood that concepts introduced herein may be applicable also for other type of power applications designed as a mobile or stationary system. Mobile systems may include heavy-duty vehicles, such as trucks, buses, construction equipment, etc. Mobile systems may also include marine vessels, such as leisure boats, yachts, cargo ships, fishing boats, ferries, patrol boats, etc. Stationary systems may include power systems for e.g. hospitals, data centers, remote communication stations, industrial plants, emergency shelters, off-grid solar systems, factories, telecommunication stations, etc.

The electric vehicle **1** comprises a traction voltage system, TVS **10.** The TVS **10** manages and distributes electrical power in the vehicle **1.** The TVS **10** includes one or more traction batteries and one or more electrical loads, and controls electricity flow between the batteries and loads by way of controlling an array of contactors/switches.

The electric vehicle **1** comprises a computer system **100** having processing circuitry **102.** The computer system **100** is provided for purposes of performing a weld check in the TVS **10.** The computer system **100** can take various forms within the vehicle architecture: it might be integrated as part of the TVS **10,** such as within a Battery Management Unit (BMU). The computer system **100** could function as a master controller that oversees operations of the TVS **10.** Alternatively, the computer system **100** could be external from the TVS **10** but in operative communication therewith, either fully external or as a hybrid solution with components both inside and outside the TVS **10.** Regardless of its configuration, the computer system **100** is central to ensuring the integrity of the TVS **10** by conducting weld checks and maintaining overall system reliability.

**FIG. 2** shows an exemplary TVS **10** where a weld check can be performed. It shall be noted that the TVS **10** may encompass virtually any type of circuit, with any number of elements, as long as the measurements and comparisons described herein can be executed. Hence, other exemplary TVS configurations may include a plurality of traction batteries, loads, or contactors, offering flexibility in its configuration and application.

The TVS **10** includes a traction battery **20** as a primary power source. The traction battery **20** may include lithium-ion batteries, nickel-metal hydride batteries, solid-state batteries, or the like. Energy supplied by the traction battery **20** flows through an electrical circuit **15** throughout various components, including an electrical load **40.** The electrical load **40** represents the end-user of this power, and may include an electric motor, battery charger, fuel cell system, auxiliary power system, or the like.

The TVS **10** comprises a set of switches, more specifically a positive and a negative switch **22, 24,** respectively. These are also referred to herein as "switch", which could be either one of the references **22** or **24,** and "initial switch", which is the other switch, and which is activated before the switch **22** or **24** (this will be discussed in more detail later). A switch as defined herein refers to an electrical device used to control the flow of electricity within the electrical circuit **15,** acting as a mechanism that opens or closes the circuit to enable or interrupt the flow of electric current. The switch may be a contactor, i.e., a type of switch designed for high-current applications, typically used to control large electrical loads **40.** Opening and closing of the switches **22, 24** may be controlled by the processing circuitry **102,** for instance by sending a control signal to a switch actuator that activates the switch **22, 24.**

The initial switch **22** is connected to the traction battery **20** and the electrical load **24,** and can be either the negative or positive switch, depending on the direction of current flow. In contrast, the switch **24** is configured with the opposite polarity to the initial switch **22,** together allowing for comprehensive control over the electrical flow and ensuring that power can be managed or isolated as required. Together, these switches **22, 24** create an integrated system capable of efficient power management.

By way of closing or opening the switches **22, 24,** the electrical circuit **15** can be closed or opened at a divide (here depicted by the centre line, however do note that this is typically not 'centre' per definition on all available traction voltage systems, just in this exemplary illustration). At respective sides of this divide are a battery-side **10-1** (also known as an internal side) and a load side **10-2** (also known as an external side). The battery side **10-1** refers to the portion of the circuit **15** that is directly connected to and originates from the traction battery **20.** This side **10-1** encompasses components that are integral to the initial distribution and management of power from the traction battery **20,** including switches, contactors, and measurement points before reaching the central divide at the line. Conversely, the load side **10-2** refers to the portion of the circuit **15** beyond the centre line, where the electrical power is delivered to the electrical load **40.** This side handles the distribution of power to end-use components and may include additional switches, contactors, and measurement points to manage and monitor the power flow effectively. The centre line represents the boundary between these two sides, where the switches **22, 24** can open or close the circuit **15** to control power flow between the traction battery **20** and the load **40.**

In this disclosure, the two sides **10-1, 10-2** have implications other than just being referred to as sides. Specifically, the present disclosure makes use of these distinct sides **10-1, 10-2** for purposes of taking voltage measurements. As illustrated in the figure, four measurement points are highlighted, where voltages *V₁* through *V₄* can be measured in computer-controlled ways for purposes of determining the presence of a weld in at least the switch **22, 24,** and possibly also in the initial switch **24, 22.** Generally, a voltage refers to the electrical potential difference measured between two points in a circuit, for example across two poles or terminals, or a ground reference. This measurement provides insight into the voltage level within a specific section of the electrical circuit **15.** It shall be understood that Isolation Resistance Monitoring, IRM, is enabled on the battery side **10-1** during voltage measurements to easier distinguish the two sides **10-1, 10-2** from one another and for safety reasons.

The determination of a weld's presence in the TVS **10** depends on which switch, **22, 24** is opened. When the initial switch **22** is opened, the voltage *V₃*, being a pole-to-pole voltage over the electrical load **40,** is measured at a measurement point. The presence of the weld is identified where a voltage drop exceeds a voltage threshold limit. This can be done due to the fact that, whenever the initial switch **22** opens, it physically separates its contacts, breaking the electrical connection and interrupting current flow. This causes the voltage *V₃* to drop as the circuit **15** is no longer complete. A drop in voltage *V₃* exceeding the voltage threshold limit therefore confirms the initial switch **22** is not welded because welded contacts would maintain electrical continuity, preventing the voltage from falling. This behavior verifies the proper functioning of the initial switch **22** and ensures the circuit is safely interrupted. Conversely, where no voltage drop is identified, this is likely the cause of a weld being present that prevents the voltage from dropping as would have been expected.

The voltage threshold limit for identifying the weld is typically set to zero or close to zero, such as 5V, even when dealing with a TVS **10** configured for higher voltage levels, such as 450V. Generally, the voltage threshold limit is determined based on the characteristics of the TVS **10,** ensuring that any significant deviation from expected voltage drops is captured. By setting the threshold near zero, minor discrepancies indicative of a weld can be detected. It shall be noted that the determination should be conditioned on some time period to allow enough time for the measurements to stabilize, providing a reliable value that informs the decision regarding the presence of a weld. This time period may be set based on empirical testing and/or operational requirements, often being a few seconds to ensure accuracy without causing unnecessary delays in diagnostics.

To determine the presence of a weld in the initial switch **22,** a reliable reference voltage is used. *V₄,* the pole-to-pole voltage over the traction battery **20,** serves as this reference. While it may not be directly measured in each diagnostic cycle, *V₄* should be calculated or known based on for example specifications and/or historical performance data of the TVS **10** or traction voltage systems with similar characteristics and/or operating conditions. By using *V₄* as a reference, voltage drop assessments can be observed in the third voltage, *V₃*, allowing for identification of deviations that might indicate a weld.

Once the initial switch **22** is optionally determined to be functioning correctly and not welded according to the above, the procedure of detecting a weld in the switch **24** can begin. The first step involves opening the switch **24.** While the switch **24** is open, two voltage measurements are taken.

First, the voltage, *V₁,* is measured between the traction battery **20** and the ground reference **30-1** at the battery side **10-1** of the traction voltage system **10.** When measuring the voltage *V₁* between the traction battery **20** and ground reference **30-1** at the battery side **10-1,** it involves determining the voltage difference between the terminal of the traction battery **20** and a stable ground point, typically a chassis ground point. This measurement assesses output voltage of the traction battery **20** and ensuring it is delivering the expected power level.

Then, the voltage, *V₂,* is measured between the electrical load **50** and the ground reference **30** at the load side **10-2.** This measurement captures the voltage across the terminals of the electrical load **40,** here also relative to the stable ground point, typically a chassis ground point. This measurement assesses the voltage being supplied to the electrical load **40,** ensuring it receives the correct power to function effectively.

The processing circuitry **102** may measure the voltages *V₁, V₂* by using an analog-to-digital converter (ADC). The processing circuitry **102** can obtain input voltages that has been sampled by the ADC from the electrical circuit **15.** These sampled voltages are then processed to calculate the voltages *V₁, V₂.*

The ground reference points may be in a parallel connection with a respective resistor **28, 29.** This configuration may allow the measurements to be taken across the various sides **10-1, 10-2** without interrupting the main circuit flow. The parallel connection ensures that the resistors **28, 29** do not impact the overall current path of the electrical circuit **15,** providing a stable reference for the measurement.

When the voltages *V₁, V₂* have been measured, still while the switch **24** is opened, the processing circuitry **102** compares them. This involves analyzing the voltages *V₁, V₂* to detect any inconsistencies that may indicate the presence of a weld. Typically, the first voltage, *V₁*, should differ from the second voltage *V₁* due to the open state of the switch **24.** If both voltages remain unexpectedly similar, it may suggest that the switch **24** is welded, maintaining electrical continuity when it should be interrupted.

The processing circuitry **102** may calculate a statistical measure of the difference over a predefined time period to identify such discrepancies. A positive gradient of the statistical measure indicates the absence of a weld in the switch **24,** while a negative gradient of the statistical measure indicates the presence of a weld in the switch **24.** A "statistical measure" in this context refers to a calculated value that represents the difference between the measured voltages *V₁, V₂* over a predefined time period. This measure could be derived using various techniques, including but not limited to averaging, variance, Root Mean Square (RMS) calculations, or the like. A "gradient" refers to the rate of change in this statistical measure over time. Specifically, it indicates how the difference between *V₁, V₂* evolves as the processing circuitry **102** continues to monitor the voltages.

If the statistical measure shows an increasing trend, it suggests that the difference between the voltages *V₁*, *V₂* is growing. This indicates normal operation where the switch **24** is effectively breaking the circuit **15,** allowing expected fluctuations and variations in the voltage difference, thus signaling the absence of a weld. Conversely, a zero or stable trend in the statistical measure implies that the voltage difference is unchanging, which could indicate the presence of a weld in the switch **24.** This stability suggests persistent electrical continuity where there should be none, as the switch **24** may not be effectively interrupting the circuit **15,** causing the voltages *V₁*, *V₂* to remain more aligned than expected.

By analyzing these gradients, the processing circuitry **102** can effectively determine the operational state of switch **24,** ensuring accurate diagnostics and maintaining system integrity.

By analyzing the voltages' gradients over time, the subtle discrepancies can be identified which may indicate partial welding. This nuanced detection ensures that any degradation in the functionality of the switch **24** is identified early, allowing for preventive maintenance and reducing the risk of complete failure or safety hazards. Such detailed monitoring of the contact surface conditions enhances the ability to maintain operational integrity and safety. Hence, this disclosure relates to performing an at least partial weld check.

In an example using RMS calculations, the following formula is used, where *V_{RMS_diff}* is the statistical measure, *V₁* is the voltage between the traction battery **20** and ground reference **30-1** at the battery side **10-1,** and *V₂* is the voltage between the electrical load **50** and the ground reference **30** at the load side **10-2:** ${V}_{RMS _ diff} = \sqrt{\frac{1}{N} {\sum }_{i = 1}^{N} {\left({V}_{1}-{V}_{2}\right)}^{2}}$

The predefined time period referred to above may vary depending on various factors. The processing circuitry **102** may set the time period, for example based on previous operations or based on system characteristics. In particular examples this period is set to at least three seconds, allowing the processing circuitry **102** to observe meaningful changes in the voltage readings, thus providing a reliable indication of whether a weld is present. The period of at least three seconds is based on empirical tests and operational experience, which suggest that a span of three seconds is typically sufficient to capture the dynamic behavior of the circuit when a switch opens. While a fixed value of three seconds is used here as a reference period, different scenarios may warrant other fixed durations, e.g., 0.5 seconds, 2 seconds, 5 seconds, 10 seconds, or other suitable fixed value.

In some examples, the time period might be adaptive, adjusting based on the specific behavior of the voltage readings. A shorter duration, such as 0.5 seconds, could suffice if the system detects rapid changes indicative of a weld. Conversely, longer periods may be beneficial for capturing more data, allowing to achieve statistical significance in its analysis, such as 5 seconds. The value may adapt to assume any value between these two values or more, for instance. However, it shall be understood that there is a practical limit beyond which extended observation yields diminishing returns.

During the predefined time period, the processing circuitry **102** can detect trends or gradients in the voltage measurements, ensuring that transient fluctuations or noise do not lead to false positives. The (at least) three-second limit strikes a balance between providing enough time to observe changes and maintaining a swift diagnostic process that does not unduly delay operations.

In the specific example of **FIG. 2****,** the switch **22** is located on the positive side of the circuit **15.** This setup allows for flexibility in measurement, as you could open either the positive or negative side to perform weld check assessment. In some alternative configurations, by calculating the voltage difference between *V₃* and *V₂* on the load side **10-2,** it is possible to detect the presence of a weld. Similarly, on the battery side **10-1,** the difference between *V₄* and *V₁* can be calculated to perform the weld check on the negative side. This approach ensures comprehensive diagnostics by leveraging voltage differences, regardless of which side is being examined.

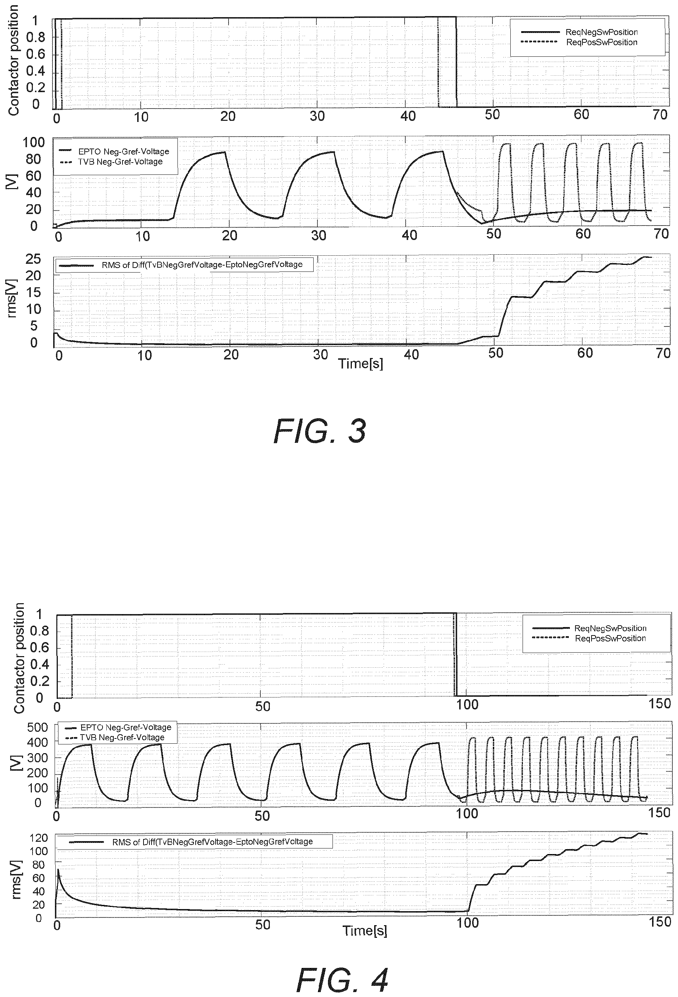

**FIG. 3** show three diagrams of data in an implementation of a weld check method using a first exemplary TVS **10.** Here, the TVS **10** is designed to supply power at 100V.

In the top diagram, switch positions are plotted over time, with the Y-axis representing position (1 = closed, 0 = open) and the X-axis time in seconds. Initially, both the negative and positive switches **22, 24** remain in a closed position. Around 45 seconds, there is a shift as the requested positions for both switches change **22, 24,** indicating their operation to open or close at specific intervals.

The middle diagram tracks voltage over time, with the Y-axis showing voltage levels and the X-axis time. Initially, both the load **40** (here an electric power take-off, EPTO) and the battery **20** (traction voltage battery, TVB) remain low. Around 15 seconds, the TVB voltage rises, indicating an increase in power delivery. This is followed by periodic fluctuations, where the voltages dip and rise, reflecting changes in load and supply conditions. After 45 seconds, the significant fluctuations in the TVB voltage, while the EPTO voltage remains low, relate to the requested switch positions. The change in switch positions around this time causes the battery **20** to experience dynamic load adjustments, leading to voltage variations. The EPTO voltage staying low suggests that the load **40** remains disconnected or under a stable load, unaffected by the adjustments impacting the battery **20.** This behavior indicates how changes in switch positions directly influence voltage stability and distribution within the TVS **10.**

The bottom diagram illustrates the RMS of the difference between negative ground reference voltages of the battery **20** and the load **40,** i.e., voltages *V₁* and *V₂* discussed herein. This value is analyzed to determine the weld status of the switch **24.** Initially, the RMS value is stable, indicating minimal difference. After 45 seconds, the RMS value begins to rise, showing an increasing discrepancy between *V₁* and *V₂.* This trend continues, with fluctuations aligning with the middle diagram's voltage changes. The upward trend in RMS after 45 seconds suggests a positive gradient, potentially indicating the absence of a weld, as the voltage difference increases rather than stabilizing. Conversely, a zero gradient would potentially highlight issues with switch integrity, i.e. the presence of a weld.

**FIG. 4** show three diagrams of data in an implementation of a weld check method using a second exemplary TVS **10.** Here, the TVS **10** is designed to supply power at 450V.

In the top diagram, switch positions are displayed over time, with the Y-axis indicating whether the switches **22, 24** are open (0) or closed (1) and the X-axis showing time in seconds. Initially, both the negative and positive switches **22, 24** remain closed, ensuring continuity of the circuit **15.** Around 100 seconds, a significant shift occurs as the requested positions for both switches **22, 24** change, indicating their operation to open or close at specified intervals.

The middle diagram tracks voltage levels over time, comparing ground reference voltages *V₁, V₂* of the load **40** and the battery **20.** Initially, both voltages rise, reflecting an initial power surge. Subsequently, the voltages *V₁*, *V₂* display periodic fluctuations, aligning with the opening and closing of the switches **22, 24.** After 100 seconds, the voltage *V₁* shows more pronounced oscillations, while the voltage *V₂* stabilizes at a lower level, suggesting that the load remains steady or disconnected.

The bottom diagram presents the RMS of the difference between the battery and load voltages *V₁, V₂.* This value is analyzed to determine the weld status of the switch **24.** Initially, the RMS value indicates a voltage discrepancy. As time progresses, the RMS value decreases, reflecting an alignment in voltage behavior. However, after 100 seconds, the RMS value trends upward again, suggesting a positive gradient that may indicate the absence of a weld. Conversely, a zero gradient would potentially highlight issues with switch integrity, i.e. the presence of a weld.

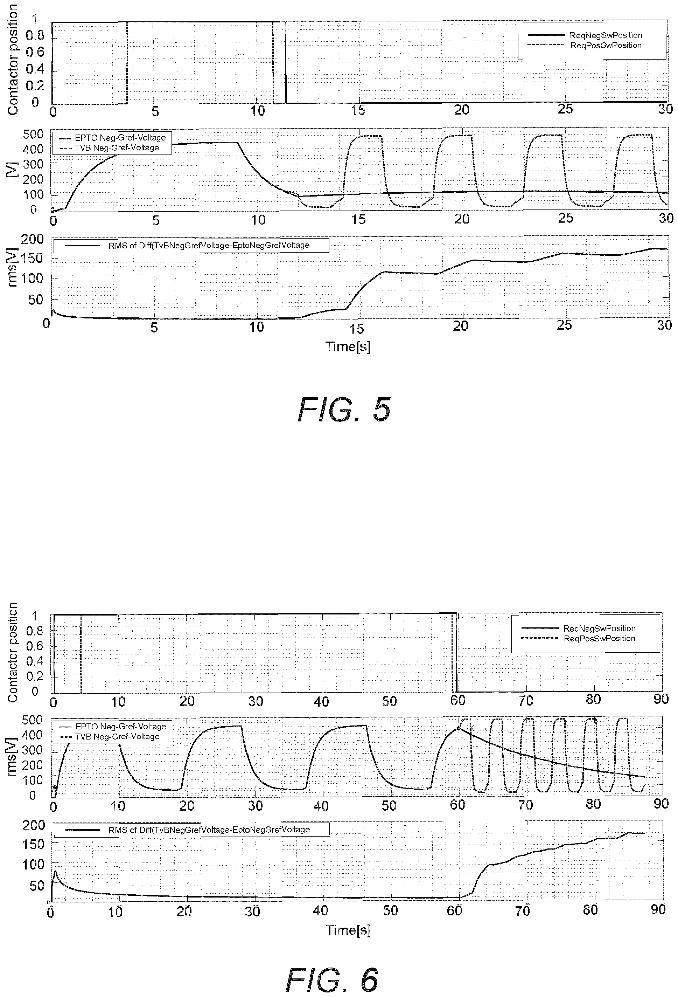

Like **FIGs. 3-4****,** **FIGs. 5-6** show three diagrams of data in an implementation of a weld check method using a third and fourth exemplary TVS **10,** respectively. In **FIG. 5****,** the TVS **10** is designed to supply power at 500V, and in **FIG. 6****,** the TVS **10** is designed to supply power at 750V.

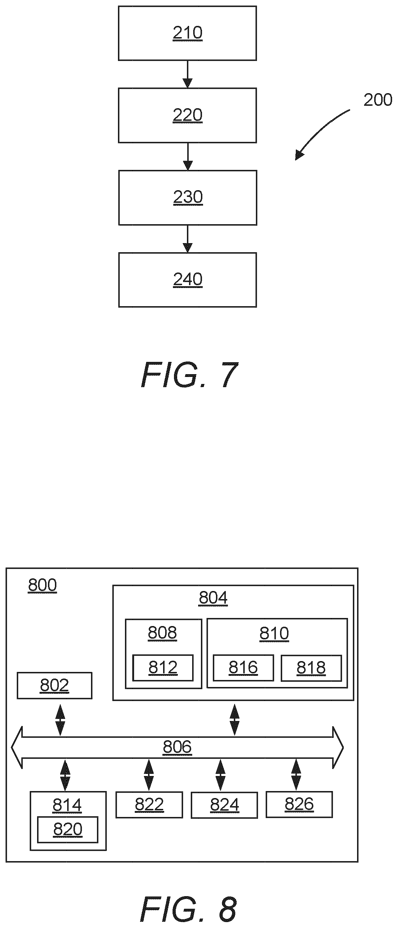

**FIG. 7** shows an exemplary flowchart of a method **200** for performing weld performing a weld check in a traction voltage system **10.** The steps of the method **200** is carried out by processing circuitry **102** of a computer system **100.** The method **200** comprises a step **210** of opening **210** a switch **22, 24** connected to the traction battery **20.** The method **200** comprises a step **220** of measuring a first voltage, *V₁,* between the traction battery **20** and ground reference **30,** the first voltage, *V₁,* being measured at a battery side **10-1** of the traction voltage system **10** in relation to the switch **22, 24.** The method **200** comprises a step **230** of measuring a second voltage, *V₂,* between an electrical load **40** and ground reference **30,** the second voltage, *V₂,* being measured at a load side **10-2** of the traction voltage system **10** in relation to the switch **22, 24.** The method **200** comprises a step **240** of comparing the first and second voltages, *V₁, V₂,* to determine the presence of a weld in the switch **22, 24.**

**FIG. 8** is a schematic diagram of a computer system **800** for implementing examples disclosed herein. The computer system **800** is adapted to execute instructions from a computer-readable medium to perform these and/or any of the functions or processing described herein. The computer system **800** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **800** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **800** may comprise at least one computing device or electronic device capable of including firmware, hardware, and/or executing software instructions to implement the functionality described herein. The computer system **800** may include processing circuitry **802** (e.g., processing circuitry including one or more processor devices or control units), a memory **804,** and a system bus **806.** The computer system **800** may include at least one computing device having the processing circuitry **802.** The system bus **806** provides an interface for system components including, but not limited to, the memory **804** and the processing circuitry **802.** The processing circuitry **802** may include any number of hardware components for conducting data or signal processing or for executing computer code stored in memory **804.** The processing circuitry **802** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **802** may further include computer executable code that controls operation of the programmable device.

The system bus **806** may be any of several types of bus structures that may further interconnect to a memory bus (with or without a memory controller), a peripheral bus, and/or a local bus using any of a variety of bus architectures. The memory **804** may be one or more devices for storing data and/or computer code for completing or facilitating methods described herein. The memory **804** may include database components, object code components, script components, or other types of information structure for supporting the various activities herein. Any distributed or local memory device may be utilized with the systems and methods of this description. The memory **804** may be communicably connected to the processing circuitry **802** (e.g., via a circuit or any other wired, wireless, or network connection) and may include computer code for executing one or more processes described herein. The memory **804** may include non-volatile memory **808** (e.g., read-only memory (ROM), erasable programmable read-only memory (EPROM), electrically erasable programmable read-only memory (EEPROM), etc.), and volatile memory **810** (e.g., random-access memory (RAM)), or any other medium which can be used to carry or store desired program code in the form of machine-executable instructions or data structures and which can be accessed by a computer or other machine with processing circuitry **802.** A basic input/output system (BIOS) **812** may be stored in the non-volatile memory **808** and can include the basic routines that help to transfer information between elements within the computer system **800.**

The computer system **800** may further include or be coupled to a non-transitory computer-readable storage medium such as the storage device **814,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **814** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **814** and/or in the volatile memory **810,** which may include an operating system **816** and/or one or more program modules **818.** All or a portion of the examples disclosed herein may be implemented as a computer program **820** stored on a transitory or non-transitory computer-usable or computer-readable storage medium (e.g., single medium or multiple media), such as the storage device **814,** which includes complex programming instructions (e.g., complex computer-readable program code) to cause the processing circuitry **802** to carry out actions described herein. Thus, the computer-readable program code of the computer program **820** can comprise software instructions for implementing the functionality of the examples described herein when executed by the processing circuitry **802.** In some examples, the storage device **814** may be a computer program product (e.g., readable storage medium) storing the computer program **820** thereon, where at least a portion of a computer program **820** may be loadable (e.g., into a processor) for implementing the functionality of the examples described herein when executed by the processing circuitry **802.** The processing circuitry **802** may serve as a controller or control system for the computer system **800** that is to implement the functionality described herein.

The computer system **800** may include an input device interface **822** configured to receive input and selections to be communicated to the computer system **800** when executing instructions, such as from a keyboard, mouse, touch-sensitive surface, etc. Such input devices may be connected to the processing circuitry **802** through the input device
interface **822** coupled to the system bus **806** but can be connected through other interfaces, such as a parallel port, an Institute of Electrical and Electronic Engineers (IEEE) 1394 serial port, a Universal Serial Bus (USB) port, an IR interface, and the like. The computer system **800** may include an output device interface **824** configured to forward output, such as to a display, a video display unit (e.g., a liquid crystal display (LCD) or a cathode ray tube (CRT)). The computer system **800** may include a communications interface **826** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: A computer system (100; 800) for performing a weld check in a traction voltage system (10), the computer system (10) comprising processing circuitry (102; 802) configured to open a switch (22, 24) connected to the traction battery (20) and an electrical load (40) of the traction voltage system (10); measure a first voltage, *V*₁, between the traction battery (20) and ground reference (30), the first voltage, *V*₁, being measured at a battery side (10-1) of the traction voltage system (10) in relation to the switch (22, 24); measure a second voltage, *V*₂, between the electrical load (40) and ground reference (30), the second voltage, *V*₂, being measured at a load side (10-2) of the traction voltage system (10) in relation to the switch (22, 24); and compare the first and second voltages, *V*₁, *V*₂, to determine the presence of a weld in the switch (22, 24).

Example 2: The computer system (100; 800) of Example 1, wherein the processing circuitry (102; 802) is configured to compare the first and second voltages, *V*₁, *V*₂, by calculating a statistical measure of the difference between the first and second voltages, *V*₁, *V*₂, over a predefined time period, wherein a positive gradient of the statistical measure indicates the absence of a weld in the switch (22, 24), and a substantially zero gradient of the statistical measure indicates the presence of a weld in the switch (22, 24).

Example 3: The computer system (100; 800) of Example 2, wherein the statistical measure is a Root Mean Square, RMS, *V_{RMS_diff}*, calculated using the formula: ${V}_{RMS _ diff} = \sqrt{\frac{1}{N} {\sum }_{i = 1}^{N} {\left({V}_{1}-{V}_{2}\right)}^{2}}$

Example 4: The computer system (100; 800) of any of Examples 2-3, wherein the predefined time period is a fixed value.

Example 5: The computer system (100; 800) of any of Examples 2-3, wherein the predefined time period is an adaptive value.

Example 6: The computer system (100; 800) of any preceding Example, wherein the processing circuitry (102; 802) is further configured to, prior to opening the switch (22, 24), open an initial switch (24, 22) connected to the traction battery (20), the initial switch (24, 22) having a polarity opposite that of the switch (22, 24); measure a third voltage, *V*₃, being a pole-to-pole voltage over the electrical load (40); and determine the presence of a weld in the initial switch (24, 22) in response to identifying a voltage drop in the third voltage, *V*₃, using a fourth voltage, *V*₄, being a pole-to-pole voltage over the traction battery (20), as reference.

Example 7: The computer system (100; 800) of Example 6, wherein the processing circuitry (102; 802) is further configured to set a voltage threshold limit, and wherein the presence of a weld in the initial switch (24, 22) is determined in response to the voltage drop exceeding said voltage threshold limit.

Example 8: The computer system (100; 800) of any preceding Example, wherein the processing circuitry (102; 802) is configured to open a switch (22, 24) by causing transmission of a control signal to a switch actuator.

Example 9: The computer system (100; 800) of any preceding Example, wherein the processing circuitry (102; 802) is configured to obtain sampled input voltages from an analog-to-digital converter (104), and process the sampled input voltages to measure the voltages, *V*₁, *V*₂, *V*₃, *V*₄.

Example 10: The computer system (100; 800) of any preceding Example, wherein a measurement point of the first voltage, *V*₁, is connected in parallel with a resistor (28).

Example 11: The computer system (100; 800) of any preceding Example, wherein a measurement point of the second voltage, *V*₂, is connected in parallel with a resistor (29).

Example 12: A vehicle (1) comprising an electrical load (40); a traction voltage system (10) comprising a traction battery (20) adapted to supply power to the electrical load (40); and a computer system (100; 800) of any of Examples 1-11 configured to perform a weld check in the traction voltage system (10).

Example 13: The vehicle (1) of Example 12, wherein the electrical load (40) is an electric motor, a battery charger, a fuel cell system, or an auxiliary power system.

Example 14: A computer-implemented method (200) for performing a weld check in a traction voltage system (10), comprising opening (210), by processing circuitry (102; 802) of a computer system (100; 800), a switch (22, 24) connected to the traction battery (20); measuring (220), by the processing circuitry (102; 802), a first voltage, *V*₁, between the traction battery (20) and ground reference (30), the first voltage, *V*₁, being measured at a battery side (10-1) of the traction voltage system (10) in relation to the switch (22, 24); measuring (230), by the processing circuitry (102; 802), a second voltage, *V*₂, between an electrical load (40) and ground reference (30), the second voltage, *V*₂, being measured at a load side (10-2) of the traction voltage system (10) in relation to the switch (22, 24); and comparing (240), by the processing circuitry (102; 802), the first and second voltages, *V*₁, *V*₂, to determine the presence of a weld in the switch (22, 24).

Example 15: The computer-implemented method (200) of Example 14, wherein comparing (240) the first and second voltages, *V*₁, *V*₂, further comprises, by the processing circuitry (102; 802), calculating a statistical measure of the difference between the first and second voltages, *V*₁, *V*₂, over a predefined time period, wherein a positive gradient of the statistical measure indicates the absence of a weld in the switch (22, 24), and a substantially zero gradient of the statistical measure indicates the presence of a weld in the switch (22, 24).

Example 16: The computer-implemented method (200) of Example 15, wherein the statistical measure is a Root Mean Square, RMS, value, *V_{RMS_diff}*, calculated using the formula: ${V}_{RMS _ diff} = \sqrt{\frac{1}{N} {\sum }_{i = 1}^{N} {\left({V}_{1}-{V}_{2}\right)}^{2}}$

Example 17: The computer-implemented method (200) of any of Examples 14-16, further comprising opening, by the processing circuitry (102; 802), an initial switch (24, 22) connected to the traction battery (20), the initial switch (24, 22) having a polarity opposite that of the switch (22, 24); measuring, by the processing circuitry (102; 802), a third voltage, *V*₃, being a pole-to-pole voltage, over the electrical load (40); and determining, by the processing circuitry (102; 802), the presence of a weld in the initial switch (24, 22) in response to identifying a voltage drop in the third voltage, *V*₃.

Example 18: The computer-implemented method (200) of Example 17, further comprising setting, by the processing circuitry (102; 802), a voltage threshold limit, and determining, by the processing circuitry (102; 802), the presence of a weld in the initial switch (24, 22) in response to the voltage drop exceeding said voltage threshold limit.

Example 19: A computer program product comprising program code for performing, when executed by the processing circuitry (102; 802), the computer-implemented method (200) of any of Examples 14-18.

Example 20: A non-transitory computer-readable storage medium comprising instructions, which when executed by processing circuitry (102; 802), cause the processing circuitry (102; 802) to perform the computer-implemented method (200) of any of Examples 14-18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (100; 800) for performing a weld check in a traction voltage system (10), the computer system (10) comprising processing circuitry (102; 802) configured to:
open a switch (22, 24) connected to the traction battery (20) and an electrical load (40) of the traction voltage system (10);
measure a first voltage, *V*₁, between the traction battery (20) and ground reference (30), the first voltage, *V*₁, being measured at a battery side (10-1) of the traction voltage system (10) in relation to the switch (22, 24);
measure a second voltage, *V*₂, between the electrical load (40) and ground reference (30), the second voltage, *V*₂, being measured at a load side (10-2) of the traction voltage system (10) in relation to the switch (22, 24); and
compare the first and second voltages, *V*₁, *V*₂, to determine the presence of a weld in the switch (22, 24).

2. The computer system (100; 800) of claim 1, wherein the processing circuitry (102; 802) is configured to compare the first and second voltages, *V*₁, *V*₂, by calculating a statistical measure of the difference between the first and second voltages, *V*₁, *V*₂, over a predefined time period, wherein:
a positive gradient of the statistical measure indicates the absence of a weld in the switch (22, 24), and
a substantially zero of the statistical measure indicates the presence of a weld in the switch (22, 24).

3. The computer system (100; 800) of claim 2, wherein the statistical measure is a Root Mean Square, RMS, value, *V_{RMS_diff}*, calculated using the formula: ${V}_{RMS _ diff} = \sqrt{\frac{1}{N} {\sum }_{i = 1}^{N} {\left({V}_{1}-{V}_{2}\right)}^{2}}$

4. The computer system (100; 800) of any of claims 2-3, wherein the predefined time period is a fixed value.

5. The computer system (100; 800) of any of claims 2-3, wherein the predefined time period is an adaptive value.

6. The computer system (100; 800) of any preceding claim, wherein the processing circuitry (102; 802) is further configured to, prior to opening the switch (22, 24):
open an initial switch (24, 22) connected to the traction battery (20), the initial switch (24, 22) having a polarity opposite that of the switch (22, 24);
measure a third voltage, *V*₃, being a pole-to-pole voltage over the electrical load (40); and
determine the presence of a weld in the initial switch (24, 22) in response to identifying a voltage drop in the third voltage, *V*₃, using a fourth voltage, *V*₄, being a pole-to-pole voltage over the traction battery (20), as reference.

7. The computer system (100; 800) of claim 6, wherein the processing circuitry (102; 802) is further configured to set a voltage threshold limit, and wherein the presence of a weld in the initial switch (24, 22) is determined in response to the voltage drop exceeding said voltage threshold limit.

8. The computer system (100; 800) of any preceding claim, wherein the processing circuitry (102; 802) is configured to open a switch (22, 24) by causing transmission of a control signal to a switch actuator.

9. The computer system (100; 800) of any preceding claim, wherein the processing circuitry (102; 802) is configured to:
obtain sampled input voltages from an analog-to-digital converter (104), and
process the sampled input voltages to measure the voltages, *V*₁, *V*₂, *V*₃, *V*₄.

10. The computer system (100; 800) of any preceding claim, wherein a measurement point of the first voltage, *V₁*, is connected in parallel with a resistor (28).

11. The computer system (100; 800) of any preceding claim, wherein a measurement point of the second voltage, *V₂,* is connected in parallel with a resistor (29).

12. A vehicle (1) comprising:
an electrical load (40);
a traction voltage system (10) comprising a traction battery (20) adapted to supply power to the electrical load (40); and
a computer system (100; 800) of any of claims 1-11 configured to perform a weld check in the traction voltage system (10).

13. A computer-implemented method (200) for performing a weld check in a traction voltage system (10), comprising:
opening (210), by processing circuitry (102; 802) of a computer system (100; 800), a switch (22, 24) connected to the traction battery (20);
measuring (220), by the processing circuitry (102; 802), a first voltage, *V₁,* between the traction battery (20) and ground reference (30), the first voltage, *V₁,* being measured at a battery side (10-1) of the traction voltage system (10) in relation to the switch (22, 24);
measuring (230), by the processing circuitry (102; 802), a second voltage, *V₂,* between an electrical load (40) and ground reference (30), the second voltage, *V₂,* being measured at a load side (10-2) of the traction voltage system (10) in relation to the switch (22, 24); and
comparing (240), by the processing circuitry (102; 802), the first and second voltages, *V₁, V₂,* to determine the presence of a weld in the switch (22, 24).

14. A computer program product comprising program code for performing, when executed by the processing circuitry (102; 802), the computer-implemented method (200) of claim 13.

15. A non-transitory computer-readable storage medium comprising instructions, which when executed by processing circuitry (102; 802), cause the processing circuitry (102; 802) to perform the computer-implemented method (200) of claim 13.

## Amended claims

### Amended claims in accordance with Rule 137(2) EPC.

1. A computer system (100; 800) for performing a weld check in a traction voltage system (10) comprising a traction battery (20), the computer system (10) comprising processing circuitry (102; 802) configured to:
open a switch (22, 24) connected to the traction battery (20) and an electrical load (40) of the traction voltage system (10);
measure a first voltage, *V₁*, between the traction battery (20) and ground reference (30), the first voltage, *V₁*, being measured at a battery side (10-1) of the traction voltage system (10) in relation to the switch (22, 24);
measure a second voltage, *V₂*, between the electrical load (40) and ground reference (30), the second voltage, *V₂*, being measured at a load side (10-2) of the traction voltage system (10) in relation to the switch (22, 24); and
compare the first and second voltages, *V₁*, *V₂*, to determine the presence of a weld in the switch (22, 24).

2. The computer system (100; 800) of claim 1, wherein the processing circuitry (102; 802) is configured to compare the first and second voltages, *V₁*, *V₂*, by calculating a statistical measure of the difference between the first and second voltages, *V₁*, *V₂*, over a predefined time period, wherein:
a positive gradient of the statistical measure indicates the absence of a weld in the switch (22, 24), and
a substantially zero of the statistical measure indicates the presence of a weld in the switch (22, 24).

3. The computer system (100; 800) of claim 2, wherein the statistical measure is a Root Mean Square, RMS, value, *V_{RMS_diff}*, calculated using the formula: ${V}_{RMS _ diff} = \sqrt{\frac{1}{N} {\sum }_{i = 1}^{N} {\left({V}_{1}-{V}_{2}\right)}^{2}}$

4. The computer system (100; 800) of any of claims 2-3, wherein the predefined time period is a fixed value.

5. The computer system (100; 800) of any of claims 2-3, wherein the predefined time period is an adaptive value.

6. The computer system (100; 800) of any preceding claim, wherein the processing circuitry (102; 802) is further configured to, prior to opening the switch (22, 24):
open an initial switch (24, 22) connected to the traction battery (20), the initial switch (24, 22) having a polarity opposite that of the switch (22, 24);
measure a third voltage, *V₃,* being a pole-to-pole voltage over the electrical load (40); and
determine the presence of a weld in the initial switch (24, 22) in response to identifying a voltage drop in the third voltage, *V₃,* using a fourth voltage, *V₄,* being a pole-to-pole voltage over the traction battery (20), as reference.

7. The computer system (100; 800) of claim 6, wherein the processing circuitry (102; 802) is further configured to set a voltage threshold limit, and wherein the presence of a weld in the initial switch (24, 22) is determined in response to the voltage drop exceeding said voltage threshold limit.

8. The computer system (100; 800) of any preceding claim, wherein the processing circuitry (102; 802) is configured to open a switch (22, 24) by causing transmission of a control signal to a switch actuator.

9. The computer system (100; 800) of any preceding claim, wherein the processing circuitry (102; 802) is configured to:
obtain sampled input voltages from an analog-to-digital converter (104), and
process the sampled input voltages to measure the voltages, *V₁, V₂, V₃, V₄.*

10. The computer system (100; 800) of any preceding claim, wherein a measurement point of the first voltage, *V₁,* is connected in parallel with a resistor (28).

11. The computer system (100; 800) of any preceding claim, wherein a measurement point of the second voltage, *V₂,* is connected in parallel with a resistor (29).

12. A vehicle (1) comprising:
an electrical load (40);
a traction voltage system (10) comprising a traction battery (20) adapted to supply power to the electrical load (40); and
a computer system (100; 800) of any of claims 1-11 configured to perform a weld check in the traction voltage system (10).

13. A computer-implemented method (200) for performing a weld check in a traction voltage system (10) comprising a traction battery (20), comprising:
opening (210), by processing circuitry (102; 802) of a computer system (100; 800), a switch (22, 24) connected to the traction battery (20);
measuring (220), by the processing circuitry (102; 802), a first voltage, *V₁,* between the traction battery (20) and ground reference (30), the first voltage, *V₁*, being measured at a battery side (10-1) of the traction voltage system (10) in relation to the switch (22, 24);
measuring (230), by the processing circuitry (102; 802), a second voltage, *V₂*, between an electrical load (40) and ground reference (30), the second voltage, *V₂*, being measured at a load side (10-2) of the traction voltage system (10) in relation to the switch (22, 24); and
comparing (240), by the processing circuitry (102; 802), the first and second voltages, *V₁, V₂,* to determine the presence of a weld in the switch (22, 24).

14. A computer program product comprising program code for performing, when executed by the processing circuitry (102; 802), the computer-implemented method (200) of claim 13.

15. A non-transitory computer-readable storage medium comprising instructions, which when executed by processing circuitry (102; 802), cause the processing circuitry (102; 802) to perform the computer-implemented method (200) of claim 13.
